# EUROPÄISCHE PATENTANMELDUNG

(11) **EP 4 554 089 A1**
(43) Veröffentlichungstag der Anmeldung: **14.05.2025**
(21) Anmeldenummer: 24209831.7
(22) Anmeldetag: 30.10.2024
(51) Int. Cl.: H02S 40/38, H02S 99/00, H10F 19/80, H10F 55/00, H10F 55/25, H10H 29/20

(54) **FAHRZEUGAUSSENSTRUKTUR MIT SOLARZELLEN UND BELEUCHTUNGSELEMENTEN**

(30) Priorität: 13.11.2023 DE 102023211216
(71) Anmelder: Magna Exteriors GmbH, 63877 Sailauf (DE)
(72) Erfinder: WEYER, Tobias, 50735 Köln (DE)
(74) Vertreter: Rausch, Gabriele

(57) **Zusammenfassung**

Fahrzeugaußenstruktur (12) mit Solarpaneel (1), wobei eine Basisplatte entweder von der Fahrzeugaußenstruktur oder von einer davon separaten Basisplatte (2) gebildet ist, die eine Schicht von monokristallinen Solarzellen (4) oder eine Dünnschicht-Photovoltaik (4) trägt, die zur Fahrzeugaußenfläche hin abgedeckt sind, wobei im Schichtaufbau des Solarpaneels (1) in einer der Schichten Beleuchtungselemente verbaut sind.

## Beschreibung

Die vorliegende Erfindung betrifft eine Fahrzeugaußenstruktur mit Solarzellen und Beleuchtungselementen.

### STAND DER TECHNIK

Bei vielen Elektrofahrzeugen werden Energiemanagement, Energiegewinnung oder Energieoptimierung immer wichtiger, gerade wenn man bedenkt wie viele Bauteile beleuchtet werden. Um einen Teil dieser Energie wiederzugewinnen, kommen Solarpaneele zum Einsatz.

EP 2 878 518 B1 zeigt eine Solarzelleneinheit mit einer Vielzahl von Solarzellen, die in planarer Form in Abständen voneinander angeordnet sind, und ein Versiegelungsharz, das die Vielzahl von Solarzellen abdichtet, sowie ein Dachpaneel, das transparent ist und zum Abdecken angeordnet ist, die Solarzelleneinheit von oben abdeckt und ein Verstärkungselement, das unter der Solarzelleneinheit angeordnet ist.

Vorteilhaft für Fahrzeuge sind Foliensolarpaneele, die einfache an Konturen angepasst werden können.

DE 10 2012 200 864 A1 betrifft ein Verfahren zur Herstellung eines Formteils mit mindestens einem Organischen-Photovoltaik-Modul. Um formstabile Photovoltaik-Module für beliebig geformte Flächen zur Verfügung zu stellen, umfasst das Verfahren die Verfahrensschritte: a) Fertigen mindestens eines Organischen-Photovoltaik-Moduls auf einem planaren Substrat; b) Formen des mit dem mindestens einen Organischem-Photovoltaik-Modul versehenen Substrats derart, dass mindestens ein gekrümmter Flächenabschnitt ausgebildet wird, welcher mindestens ein Organisches-Photovoltaik-Modul aufweist; und c) Fixieren der in Verfahrensschritt b) gegebenen Form. Darüber hinaus werden Formteile vorgestellt, bei denen mindestens ein gekrümmter Flächenabschnitt mindestens ein Organisches-Photovoltaik-Modul aufweist.

EP 3 802 289 B1 zeigt eine Ausgestaltung, bei der eine Solarzellenfolie unmittelbar auf den Faserverbundkunststoff des Außenteils aufgebracht wird. Derartige photovoltaisch aktive Solarzellenfolien sind äußerst dünne Folien mit daran entsprechend ausgebildeten Solarzellen. Solche flexiblen Solarzellenfolien bestehen aus einer dünnen Trägerfolie, beispielsweise aus Polyimid, auf die eine photovoltaisch aktive Schicht beispielsweise aus Cadmiumtellurid aufgebracht wird, die gegebenenfalls rückseitig von einer weiteren extrem dünnen Trägerfolie beispielsweise aus Polyimid eingefasst ist. Der gesamte Folien- oder Schichtaufbau ist extrem dünn und daher äußerst flexibel. In einer besonders vorteilhaften Ausführungsform kann dabei vorgesehen sein, dass der Solarzellenabschnitt mit einer transparenten Lackschicht überzogen ist. Dabei kann der Lack der Lackschicht beispielsweise ein Epoxilack und/oder ein Polyimidlack sein. Eine derartige Ausgestaltung ermöglicht es zum einen, im Solarzellenabschnitt auf eine entsprechende Schutzschicht/Deckschicht zu verzichten bzw. diese einfacher auszugestalten, zum anderen aber, die Außenfläche letztlich komplett in einem Durchgang zu lackieren.

Unabhängig von der Art der Solarpaneel, ob starr oder folienflexibel, besteht ein Bedarf Informationen und/oder Beleuchtungen nach außen zubringen.

Aus der WO 2022 / 224 210 A1 ist ein Fahrzeug bekannt, dass einen Rahmen Aufbau aufweist, der teilweise mit Solarpaneele bestückt ist. Die Solarpaneele werden als einzelne Zellen verbaut, so dass zwischen ihnen freie Streifen oder Zonen entstehen. In diesen Streifen oder Zonen werden LED Lichtquellen verbaut.

Aus der WO 2021 / 009 719 A1 ist ein Solarpanel bekannt, wie es für die Verwendung als Anzeige in der Stadt und auf dem Land eingesetzt wird.

Das beschriebene Solarpanel weist einen Aufbau auf, der die Solarzelle zwischen abdeckenden Folien zeigt, und wobei dieses photoaktive Paket auf einer Rückwand installiert ist. Abgedeckt wird das Ganze mit einer Glasscheibe. Auf der eigentlichen Solarzelle ist eine Displayschicht aufgebracht, die Lichtquellen aufweist.

Die Aufgabe wird gelöst mit einer Fahrzeugaußenstruktur für den Außenbereiche eines Fahrzeugs, das Solarpaneele trägt und über LEDs in den Solarpaneelen beleuchtet ist.

### ZUSAMMENFASSUNG DER ERFINDUNG

Die Aufgabe wird gelöst mit eine Fahrzeugaußenstruktur mit Solarpaneel, wobei einen Basisplatte entweder von der Fahrzeugaußenstruktur oder von einer davon separaten Basisplatte gebildet ist, die eine Schicht von monokristallinen Solarzellen oder eine Dünnschicht-Photovoltaik trägt, die zur Fahrzeugaußenfläche hin abgedeckt sind, wobei im Schichtaufbau des Solarpaneels in einer der Schichten Beleuchtungselemente verbaut sind.

Dabei ist die Schicht der Solarzellen oder der Dünnschicht-Photovoltaik von Kunststofffolien umgeben ist.

Die abdeckende Schicht ist eine Lackschicht.

Es ist von Vorteil, dass die Beleuchtungselemente in Öffnungen zwischen monokristallinen Solarzellen oder in Aussparungen der Dünnschicht-Photovoltaik verbaut sind.

Die Beleuchtungselemente sind in der Basisplatte oder den Kunststofffolien oder der abdeckenden Schicht verbaut.

Dabei ist es vorteilhaft, dass die Beleuchtungselemente einzeln ansteuerbar sind und als Anzeigeelemente dienen.

Die in den Solarpaneelen erzeugte Energie wird in einer Batterie des Fahrzeugs gespeichert, wobei eine separate Batterie für mindestens ein Solarpaneel nahe am einem der Solarpaneele verbaut ist.

### KURZE BESCHREIBUNG DER ZEICHNUNGEN

Fig. 1 zeigt einen Aufbau eines Solarpanels,
Fig. 2 zeigt ein Solarpanel mit LEDs,
Fig.3 zeigt einen Aufbau auf einer Fahrzeugaußenhaut.

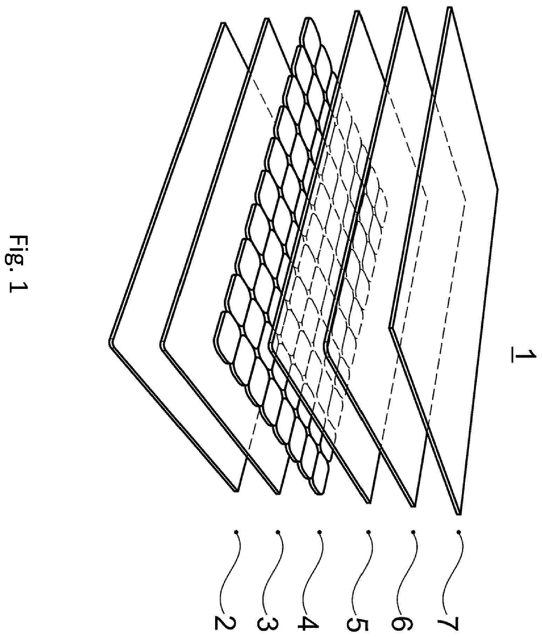

In der Figur 1 ist ein bekannter Schichtaufbau für ein Solarpaneel dargelegt. Das Solarpaneel 1 wird auf einer Basisplatte 2 aufgebaut, wobei diese Basisplatte eine Glasplatte oder eine Kunststofffolie sein kann. Es folgt eine Kunststoffschicht 3. Als nächste Schicht werden Solarzellen 4, die bereits elektrisch vorverbunden sind, verbaut. Die Solarzellen werden von einer weiteren Kunststoffschicht 5 bedeckt, die zusammen mit der Kunststoffschicht 3 eine Isolierung und Abdichtung für die Solarzellen 4 darstellen. Frontseitig wird ein Frontglas oder eine Frontfolie 6 verbaut, die von einem Rahmen 7 gehalten ist.

Im gezeigten Stand der Technik sind monokristalline Solarzellen 4 dargestellt, die in Reihe verschaltet werden. Für die erfindungsgemäße Lösung lassen sich auch Solarpaneele mit Dünnschichttechnologie verwenden.

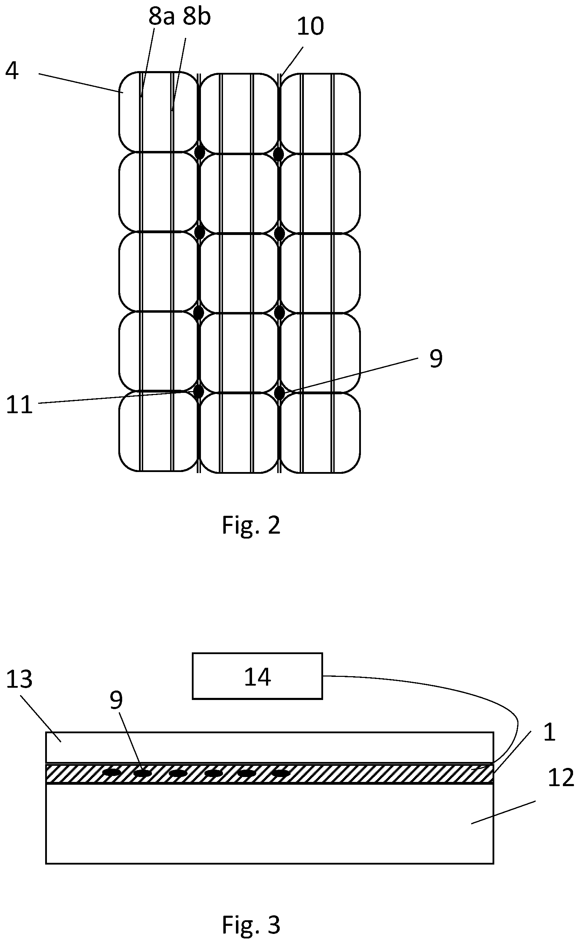

In Figur 2 sind kristalline Solarzellen 4 dargestellt. Die Solarzellen 4 sind in Reihe angeordnet und werden über Kontaktierung 8a und 8b elektrisch kontaktiert. Dabei sind in diesem Beispiel gezeigt, dass die fünf übereinander liegenden Solarzellen in Reihe geschaltet sind. Die daneben liegende Reihe von Solarzellen 4 ist ebenfalls in Reihe geschaltet.

Eine einzelne kristalline Solarzelle 4 weist in diesem Ausführungsbeispiel abgeflachte Ecken bei einer quadratischen Grundfläche auf. Dadurch ergibt sich im Zusammenbau jeweils eine Öffnung 11, die im Kontaktbereich von vier Solarzellen liegt.

In diese Öffnung 11 wird jeweils mindestens eine LED 9 eingelegt. Die LEDs 9 sind ebenfalls in Reihe miteinander verbunden und sitzen auf einem Leitungsband 10. Die Ansteuerung und Versorgung der LEDs über das Leitungsband 10 kann aber auch getrennt voneinander erfolgen.

Möchte man eine andere Anordnung der LEDs 9 haben, müssen die Solarzellen 4 eine andere Form und Größe aufweisen.

Auch bei Verwendung einer Dünnschichttechnologie für das Auftragen der fotosensitiven Schichten ist der Einbau von LEDs 9 möglich. Dazu müssen bei dem Auftragen der fotosensitiven Materialien Aussparungen vorgesehen sein, damit in diesen Aussparungen LEDs 9 montiert werden können.

In einer weiteren Ausführungsform sind die LEDs 9 nicht in der Schicht der Solarzellen 4 verbaut, sondern in einer der Kunststoffschichten 3, 5 oder sogar in dem Frontglas oder der Frontfolie 6.

Bei der Verwendung von transparenten Solarzellen ist eine Installation der LEDs auch in der Basisplatte 2 möglich.

Die elektrische Anbindung der LEDs 9 erfolgt über Leiterbahnen, die parallel zu den Kontaktierungen der Solarzellen verlaufen können. Die eigentlichen elektrischen Anschlüsse der Solarzellen, die sich im Rahmen 7 befinden, können auch zur Ansteuerung der LEDs benutzt werden.

Möchte man über die reine Beleuchtungsfunktion der LEDs hinaus, Mitteilungen darstellen, müssen die LEDs sehr viel dichter gesetzt werden. Dafür würde sich vor allem die Dünnschichttechnologie eignen, da hier Aussparungen einfach herstellbar sind. In die Aussparungen werden dann LEDs 9 verbaut, die einzeln angesteuert werden können und so eine Bildschirmfunktion darstellen.

In Figur 3 ist gezeigt, wie der Aufbau an einem Fahrzeug erfolgen kann. Ein Bauteil der Fahrzeugaußenstruktur 12 ist von einem flexiblen Solarpaneel 1 bedeckt. Im Solarpaneel 1 sind LEDs 9 verbaut, wobei es nicht darauf ankommt, in welcher Schicht des Aufbaus die LEDs 9 eingebaut werden. Das Solarpaneel 1 wird am Fahrzeug von einer transparenten Lackschicht 13 abgedeckt.

Die gesammelte Energie des Solarpaneels wird in eine Batterie 14 des Fahrzeugs eingespeist.

Dabei ist es nicht relevant, ob es sich um eine Fahrzeugbatterie oder eine separate Batterie handelt, die man in der Nähe des jeweiligen Solarpaneels verbaut. Dabei ist die bauliche Nähe so definiert, dass die separate Batterie 14 über einen kürzere Kabelverbindung zwischen Solarpaneel 1 und Batterie 14 verfügt als die Kabelverbindung zwischen Solarpaneel 1 und der Fahrzeugbatterie.

Wenn die Batterie direkt am Solarpaneel verbaut ist, kann man ein Solarmodul gestalten, das als ein Modul am Fahrzeug verbaut wird.

## Patentansprüche

1. Fahrzeugaußenstruktur (12) mit Solarpaneel (1), wobei eine Basisplatte entweder von der Fahrzeugaußenstruktur oder von einer davon separaten Basisplatte (2) gebildet ist, die eine Schicht von monokristallinen Solarzellen (4) oder eine Dünnschicht-Photovoltaik (4) trägt, die zur Fahrzeugaußenfläche hin mit einer abdeckenden Schicht abgedeckt sind, **dadurch gekennzeichnet, dass** im Schichtaufbau des Solarpaneels (1) in einer der Schichten Beleuchtungselemente verbaut sind, wobei die Schicht der monokristallinen Solarzellen (4) oder der Dünnschicht-Photovoltaik von Schichten aus Kunststofffolien (3, 5) umgeben ist und die abdeckende Schicht eine Lackschicht (13) ist.

2. Fahrzeugaußenstruktur (12) nach Anspruch 1, **dadurch gekennzeichnet, dass** die Beleuchtungselemente in Öffnungen (11) zwischen monokristallinen Solarzellen (4) oder in Aussparungen der Dünnschicht-Photovoltaik verbaut sind.

3. Fahrzeugaußenstruktur (12) nach Anspruch 1, **dadurch gekennzeichnet, dass** die Beleuchtungselemente in der Basisplatte (2) oder den Kunststofffolien (3, 5) oder der abdeckenden Lackschicht (13) verbaut sind.

4. Fahrzeugaußenstruktur (12) nach Anspruch 1 , **dadurch gekennzeichnet, dass** die Beleuchtungselemente LEDs (9) sind.

5. Fahrzeugaußenstruktur (12) nach Anspruch 1, **dadurch gekennzeichnet, dass** die Beleuchtungselemente einzeln ansteuerbar sind und als Anzeigeelemente dienen.

6. Fahrzeugaußenstruktur (12) nach Anspruch 1, **dadurch gekennzeichnet, dass** die in den Solarpaneelen erzeugte Energie in einer Batterie des Fahrzeugs gespeichert wird, wobei eine separate Batterie (14) für mindestens ein Solarpaneel (1) nahe am einem der Solarpaneele verbaut ist.
